# EUROPEAN PATENT APPLICATION

(11) **EP 2 138 521 A1**
(43) Date of publication of application: **30.12.2009**
(21) Application number: 08740643.5
(22) Date of filing: 18.04.2008
(51) Int. Cl.: C08G 59/24, C08J 5/24

(54) **EPOXY COMPOSITION**

(30) Priority: 19.04.2007 JP 2007110173
(71) Applicant: Sumitomo Chemical Company, Limited, Tokyo 104-8260 (JP); Hitachi Ltd., Chiyoda-ku Tokyo 100-8280 (JP)
(72) Inventor: TANAKA, Shinya, Toyono-gun Osaka 563-0103 (JP); TAKEZAWA, Yoshitaka Hitachi Research Laboratory, Hitachi, Ltd., Ibaraki 3191292 (JP)
(74) Representative: Vossius & Partner
(86) International application number: PCT/JP2008/057588
(87) International publication number: WO 2008/130028

(57) **Abstract**

There is disclosed an epoxy composition containing at least two kinds of epoxy compounds selected from the epoxy compounds of the formula (1) : 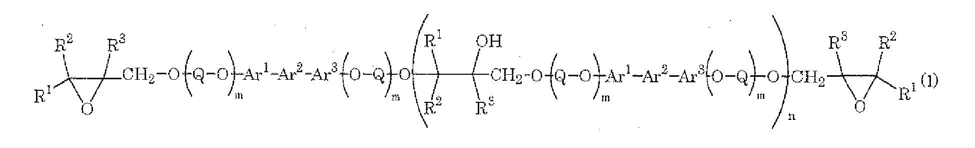 wherein
each of Ar¹, Ar² and Ar³, the same as or different from one another, is a bivalent group of any one of the following formulas: 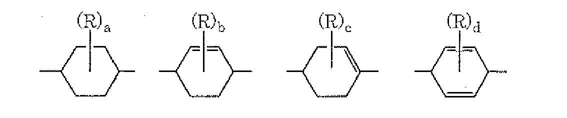 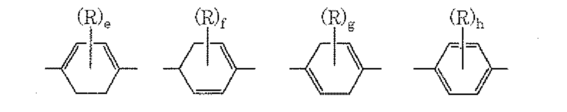 wherein R is a hydrogen atom or a C₁₋₈ alkyl group; a is an integer of 1 to 8; each of b, e and g is an integer of 1 to 6; c is an integer of 1 to 7; each of d and h is an integer of 1 to 4; and f is an integer of 1 to 5, wherein, when there are present a plurality of Rs in said bivalent group, Rs may be all the same groups or may be different groups from one another;
Q is a C₁₋₈ linear alkylene group, wherein a methylene group constituting the linear alkylene group may be substituted with a C₁₋ₛ alkyl group, and wherein a methylene group, not adjacent to an oxygen atom, may be replaced by - O-, and -O- or -N(R⁴)- may be inserted between methylene groups;
each of R¹, R², R³ and R⁴, the same as or different from one another, is a hydrogen atom or a C₁₋₈ alkyl group;
m is 0 or 1; and
n is an integer of 0 to 10.

## Description

### Technical Field

This application claims priority under the Paris Convention on Japanese Patent Application No. 2007-110173, the disclosure of which is incorporated by reference herein.
The present invention relates to a resin composition.

### Background Art

U.S. Patent No. 5,811,504 and EP 1698625 Al disclose that a cured resin obtained by curing an epoxy compound having a mesogen group using a curing agent such as a diamine compound exhibits liquid crystallinity.
Patent Document 1: U.S. Patent No. 5,811,504
Patent Document 2: EP 1698625 A1

### DISCLOSURE OF THE INVENTION

The present invention is intended to provide the following:
<1> An epoxy composition comprising at least two kinds of epoxy compounds selected from the epoxy compounds of the formula (1): 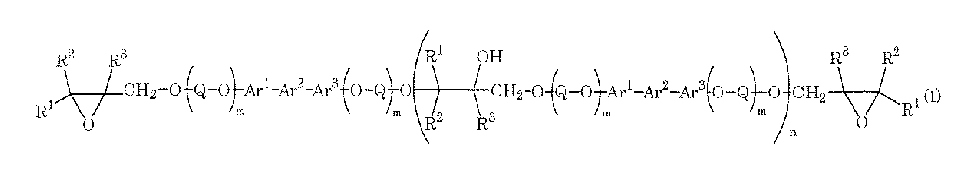 wherein
   each of Ar¹, Ar² and Ar³, the same as or different from one another, is any of the bivalent groups of the following formulas: 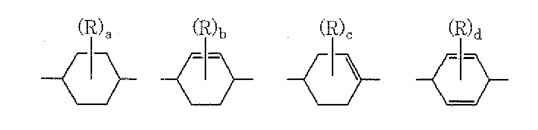 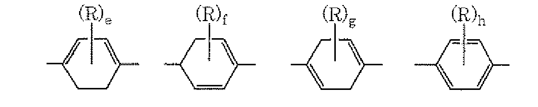 wherein R is a hydrogen atom or a C₁₋₈ alkyl group; a is an integer of 1 to 8; each of b, e and g is an integer of 1 to 6; c is an integer of 1 to 7; each of d and h is an integer of 1 to 4; and f is an integer of 1 to 5; and wherein, when the above-described bivalent group has a plurality of Rs, the Rs may be all the same groups or may be different groups from one another;
   Q is a C₁₋₈ linear alkylene group, wherein a methylene group constituting the linear alkylene group may be substituted with a C₁₋₈ alkyl group, and wherein a methylene group, not adjacent to an oxygen atom, may be replaced by - O-; and -O- or -N(R⁴)- may be inserted between each of the methylene groups;
   each of R¹, R², R³ and R⁴, the same as or different from one another, is a hydrogen atom or a C₁₋₈ alkyl group; and
   m is 0 or 1, and n is an integer of 0 to 10;

<2> the epoxy composition defined in the above item <1>, which comprises at least one kind of epoxy compound selected from the epoxy compounds of the formula (1) in which n is an integer of 1 to 10, and an epoxy compound of the formula (2): 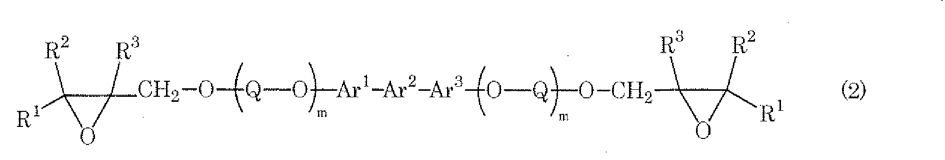 wherein Ar¹, Ar², Ar³, R¹, R², R³, Q and m are the same as defined above, respectively;

<3> the epoxy composition defined in the above item <2>, wherein the content of the epoxy compound of the formula (2) is 80% or more and 99% or less, and wherein the content of at least one kind of epoxy compound selected from the epoxy compounds of the formula (1) in which n is an integer of 1 to 10 is 1% or more and 20% or less;

<4> the epoxy composition defined in any one of the above items <1> to <3>, which further contains a curing agent;

<5> the epoxy composition defined in the above item <4>, which further contains a filler;

<6> a prepreg obtained by coating or impregnating a substrate with the epoxy composition defined in the above item <4>, and semi-curing the epoxy composition;

<7> a prepreg obtained by coating or impregnating a substrate with the epoxy composition defined in the above item <5>, and semi-curing the epoxy composition;

<8> an epoxy resin-cured product obtained by curing the epoxy composition defined in the above item <4>; and

<9> an epoxy resin-cured product obtained by curing the epoxy composition defined in the above item <5>.

### BEST MODES FOR CARRYING OUT THE INVENTION

First, the epoxy compound (1) will be illustrated.
Examples of the C₁₋₈ alkyl group include a straight-chain or branched-chain alkyl group having 1 to 8 carbon atoms such as methyl, ethyl, n-propyl, isopropyl, n-butyl, isobutyl, sec-butyl, tert-butyl, n-pentyl, tert-amyl, n-hexyl, n-octyl, isooctyl and tert-octyl group.

Examples of the bivalent group include cyclohexane-1,4-diyl, 2-cyclohexene-1,4-diyl, 1-cyclohexene-1,4-diyl, 1,4-cyclohexadiene-3,6-diyl, 1,3-cyclohexadiene-1,4-diyl, 1,3-cyclohexanediene-2,5-diyl, 1,4-cyclohexaraediene-1,4-diyl, 2-methylcyclohexane-1,4-diyl, 2-methylcyclohexene-1,4-diyl, 1,4-phenylene, 3-methyl-1,4-phenylene, 3-ethyl-1,4-phenylene, 3-n-propyl-1,4-phenylene, 3-isopropyl-1,4-phenylene, 3-n-butyl-1,4-phenylene, 3-sec-butyl-1,4-phenylene, 3-tert-butyl-1,4-phenylene, 3-n-pentyl-1,4-phenylene, 3-(1-methylbutyl)-1,4-phenylene, 3-(1,1-dimethylpropyl)-1,4-phenylene, 3-n-hexyl-1,4-phenylene, 3-(1-methylpentyl)-1,4-phenylene, 3-(2-methylpentyl)-1,4-phenylene, 3-(1-ethylbutyl)-1,4-phenylene, 3-(2-ethylbutyl)-1,4-phenylene, 3-cyclohexyl-1,4-pnenylene, 3-n-heptyl-1,4-phenylene, 3-(1-methylcyclohexyl)-1,4-phenylene, 3-n-octyl-1,4-phenylene, 3-(2-ethylhexyl)-1,4-phenylene, 3,5-dimethyl-1,4-phenylene, 3,5-diethyl-1,4-phenyleme, 3,5-di-n-propyl-1,4-phenylene, 3,5-diisopropyl-1,4-phenylene, 3,5-di-n-butyl-1,4-phenylene, 3,5-di-sec-butyl-1,4-phenylene, 3,5-di-tert-butyl-1,4-phenylene and 3,5-di-tert-amyl-1,4-phenylene group.

Examples of the C₁₋₈ linear alkylene group include groups in each of which 1 to 8 methylene group(s) are linearly bonded to one another, such as a methylene group, an ethylene group, a trimethylene group, a tetramethylene group, a hexamethylene group and an octamethylene group. The methylene group(s) constituting such a C₁₋₈ linear alkylene group may be substituted with a C₁₋₈ alkyl group, and a methylene group, not adjacent to an oxygen atom, may be replaced by -O-; and -O- or -N(R⁴)- may be inserted between each of methylene groups, wherein R⁴ is a hydrogen atom or a C₁₋₈ alkyl group. Specific examples thereof include a 2-methyltrimethylene group, a 1,2-dimethylpropylene group, a 3-oxatetramethylene group, a 3-oxapentamethylene group, etc.

Preferable is an epoxy compound of the formula (1) in which Ar¹ and Ar³, the same as or different from each other, are bivalent groups of the following: 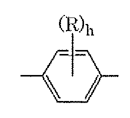 and Ar² is a bivalent group of any of the followings: 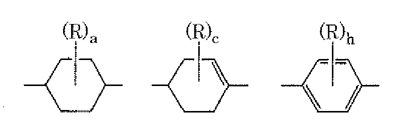 More preferable is an epoxy compound of the formula (1) in which Ar¹ and Ar³, the same as or different from each other, are bivalent groups of the following: 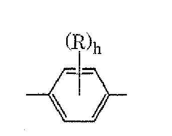 and Ar² is a bivalent group of the following: 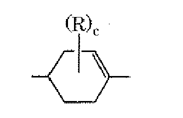 Additionally, an epoxy compound of the formula (1) in which m is zero (0) is preferable.

The epoxy composition of the present invention contains at least two kinds of epoxy compounds selected from the epoxy compounds (1). Preferably, the epoxy composition contains at least one kind of epoxy compound selected from the epoxy compounds of the formula (1) in which n is an integer of 1 to 10, and an epoxy compound of the formula (2): 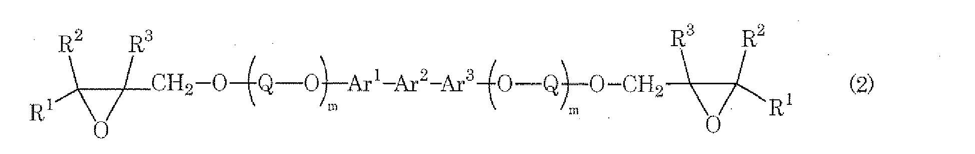 wherein Ar¹, Ar², Ar³, R¹, R², R³, Q and m are the same as defined above). Preferably, the epoxy composition contains at least one kind of epoxy compound selected from the epoxy compounds of the formula (1) in which n is an integer of 1 to 10, and the epoxy compound of the formula (2), wherein the content of the epoxy compound of the formula (2) is 80% or more and 99% or less, and wherein the content of at least one kind of epoxy compound selected from the epoxy compounds of the formula (1) in which n is an integer of 1 to 10 is from 1 to 20%.
More preferably, the epoxy composition contains at least one kind of epoxy compound selected from the epoxy compounds of the formula (1) in which n is an integer of 1 to 10, and the epoxy compound of the formula (2), wherein the content of the epoxy compound of the formula (2) is 85% or more and 99% or less, and wherein the content of at least one kind of epoxy compound selected from the epoxy compounds of the formula (1) in which n is an integer of 1 to 10 is 1% or more and 15% or less.
Preferably, at least one kind of epoxy compound selected from the epoxy compounds of the formula (1) in which n is an integer of 1 to 10 contains at least an epoxy compound of the formula (1) in which n is one (1).

Such an epoxy composition can be obtained by a method comprising reacting a compound of the formula (3) (hereinafter referred to as the compound (3)): 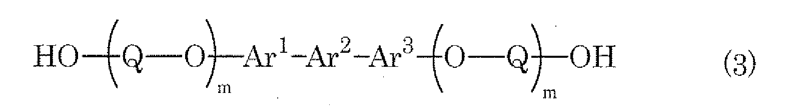 wherein, Ar¹, Ar², Ar³, Q and m are the same as defined above, with a compound of the formula (4) (hereinafter referred to as the compound (4)): 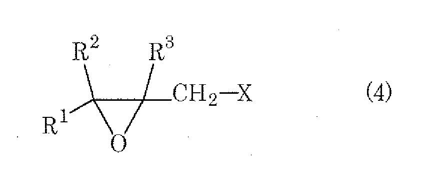 wherein R¹, R² and R³ are the same as defined above; and X is a halogen atom) in the presence of a base; washing the resulting reaction mixture with water; and removing the unreacted compound (4); mixing the resulting residue with methanol; and cooling the resulting mixture. By appropriately selecting the base to be used, the reaction temperature, the reaction time, etc., it becomes possible to control the content of the epoxy compound of the formula (1) in which n is an integer of 1 to 10, in the resultant epoxy composition. For example, when the reaction temperature is low and the reaction time is long, the resultant epoxy composition tends to contain a larger amount of at least one kind of epoxy compound selected from the epoxy compounds of the formula (1) in which n is an integer of 1 to 10.

Examples of the compound (3) include 1,4-bis(-hydroxyphenyl)cycldhexane, 1-(3-methyl-4-hydroxyphenyl)-4-(4-hydroxyphenyl)cyclohexane, 1,4-bins(4-hydroxyphenyl)cyclohexane, 1-(3-methyl-4-hydroxyphenyl)-4-(4-hydroxyphenyl) cyclohexane, 1,4-bis(4-hydroxyphenyl)-1-cyclohexene, 1-(3-methyl-4-hydroxyphenyl)-4-(4-hydroxyphenyl)-1-cyclohexene, 1,4-bis(4-hydraxyphenyl)-2-cyclohexene, 1-(3-methyl-4-hydroxyphenyl)-4-(4-hydroxyphenyl)-2-cyclohexene, 1,4-bis(4-hydroxyphenyl)-2,5-cyclohexadiene, 1-(3-methyl-4-hydroxyphenyl)-4-(4-hydraxyphenyl)-2,5-cyolohexadiene, 1,4-bins(4-hydroxyphenyl)-1,5-cyclohexadiene, 1-(3-methyl-4-hydroxyphenyl)-4-(4-hydroxyphenyl)-1,5-cyclohexadiene, 1,4-bis(4-hydroxyphenyl)-1,4-cyclohexadiene, 1-(3-methyl-4-hydxaxyphenyl)-4-(4-hydroxyphenyl)-1,4-cyclohexadiene, 1,4-bis(4-hydroxyphenyl)-1,3-cyclohexadiene, 1-(3-methyl-4-hydroxyphenyl)-4-(4-hydroxyphenyl)-1,3-cyclohexadiene, 1,4-bis(4-hydroxyphenyl)benzene, 1-(3-methyl-4-hydroxyphenyl)-4-(4-hydroxyphenyl)benzene, etc.

The compound (3) may be produced according to the procedure of the known methods described in JP-A-1-168632, JP-A-1-168634, US Patent No. 3461098, JP-A-2-212449, JP-A-2002-234856, JP-A-2002-308809, JP-A-2002-363117 and JP-A-2003-12585.

Examples of the halogen atom in the compound (4) include a chlorine atom, a bromine atom, etc. Examples of the compound (4) include epichlorohydrin, epibromohydrin, etc.
The amount of the compound (4) to be used is usually 2 to 100 moles, preferably 2 to 50 moles, per 1 mole of the compound (3).

Examples of the base include inorganic bases such as sodium hydroxide, potassium hydroxide, sodium carbonate and potassium carbonate. The amount of the base to be used is usually 2 to 10 moles, preferably 3 to 7 moles, per 1 mole of the compound (3).

Usually, the compound (3), the compound (4) and the base are mixed to thereby react the compound (3) with the compound (4).

The reaction may be carried out under a normal pressure or under reduced pressure. The reaction temperature is usually from 10 to 150°C. While water is sometimes produced as a by-product with the proceeding of the reaction, in that case, it is preferable to carry out the reaction while removing water produced as a by-product from the reaction system. Preferably, the reaction is carried out at such a reaction temperature under such a reaction pressure that water can be removed as an azeotrope.

After the completion of the reaction, the resulting reaction mixture is washed with water to obtain a solution containing the epoxy compound (1); the unreacted compound (4) is removed from the solution; the resulting residue is mixed with methanol; and the resulting mixture is cooled to precipitate the epoxy composition. The precipitated epoxy composition can be collected by filtration or the like.

Next, an epoxy resin-cured product comprising the epoxy composition of the present invention and a curing agent is described.
The epoxy resin-cured product of the present invention is obtained by mixing the epoxy composition of the present invention and a curing agent as they are, or by mixing them in a solvent. Examples of the solvent include ketone solvents such as methyl ethyl ketone and methyl isobutyl ketone; aprotic polar solvents such as dimethyl sulfoxide and N-methylpyrrolidone; ester solvents such as butyl acetate; glycol solvents such as propylene glycol monomethyl ether; and the like.

The curing agent may have at least two functional groups capable of causing a curing reaction with an epoxy group in the molecule and examples thereof include an amine type curing agent having amino groups as functional groups, a phenol type curing agent having hydroxyl groups as functional groups, and an acid anhydride type curing agent having carboxyl groups as functional groups. Among these curing agents, an amine type curing agent or a phenol type curing agent is preferred.

Examples of the amine type curing agent include aliphatic polyvalent amines having 2 to 20 carbon atoms such as ethylenediamine, trimethylenediamine, tetramethylenediamine, hexamethylenediamine, diethylenetriamine and triethylenetotramine; aromatic polyvalent amines such as p-xylenediamine, m-xylenediamine, 1,5-diaminonaphthalene, m-phenylenediamine, p-phenylenediamine, 4,4'-diaminodiphenylmethane, 4,4'-diaminodiphenylethane, 4,4'-diaminodiphenylpropane, 4,4'-diaminodiphenylether, 1,1-bis(4-aminophenyl)cyclohexane, 4,4'-diaminodiphenylsultono and bins(4-aminophenyl)hphenylmethane; alicyclic polyvalent amines such as 4,4'-diaminodicylohexane and 1,3-bis(aminomethyl)cylohexane; and dicyandiamide. Among these amine type curing agents, aromatic polyvalent amines are preferable, and 4,4'-diaminodiphenylmethane, 4,4'-diaminodiphenylethane, 1,5-diaminonaphthalene and p-phenylenediamine are more preferable.

Examples of the phenol type curing agent include phenol resin, phenol aralkyl resin (having a phenylene framework, diphenylene framework, etc.), naphthol aralkyl resin and polyoxystyrene resin. Examples of the phenol resin include resol type phenol resins such as aniline-modified resol resin and dimethyl ether resol resin; novolak type phenol resins such as phenol novolak resin, cresol novolak resin, tert-butyl phenol novolak resin and nonyl phenol novolak resin; special phenol resins such as dicyclopentadiene-modified phenol resin, terpene-modified phenol resin and triphenol methane type resin. Examples of the poloxystyrene resin include poly(p-oxystyrene).
Examples of the acid anhydride type curing agent include maleic anhydride, phthalic anhydride, pyromellitic anhydride and trimellitic anhydride.

The curing agent is used in such an amount that the total amount of functional groups capable of causing a curing reaction with an epoxy group is usually 0.5 to 1.5 times, and preferably from 0.9 to 1.1 times based on the total amount of epoxy groups in the resin composition.

The epoxy resin-cured product of the present invention may contain the above mentioned solvents as described above, another epoxy compounds and various additives other than the epoxy composition of the present invention and the curing agent. Examples of the additive include silica powders such as fused crushed silica powder, fused spherical silica powder, crystal silica powder and secondary aggregated silica powder; fillers such as alumina, aluminum nitride, boron nitride, silicon nitride, silicon carbide, titanium white, aluminum hydroxide, magnesia, talc, clay, mica and glass fiber; metals such as copper, aluminum and iron; curing accelerators such as triphenylphosphine, 1,8-azabicyclo[5.4.0]-7-undecene and 2-methylimidazole; coupling agents such as γ-glycidoxypropyltrimethoxysilane; colorants such as carbon black; low-stress components such as silicone oil and silicone rubber; mold release agents such as natural wax, synthetic wax, higher fatty acid or metal salt thereof, and paraffin; and antioxidants. Thy content of another epoxy compounds and additives may be the content which does not adversely affect desired performances of the epoxy resin-cured product according to the present invention.

The epoxy resin-cured product of the present invention can be produced by curing an epoxy composition which contains the epoxy composition of the present invention and a curing agent. Preferable is the epoxy resin-cured product obtained by curing an epoxy composition which contains the epoxy composition of the present invention, a curing agent and a filler. The resultant epoxy resin-cured product shows not only a liquid crystalline property but also a high thermal conductivity, and thus is useful, for example, as an insulating material for a printed circuit board or the like, which is required to have a high heat dissipation capacity.

Examples of the method of producing the epoxy resin-cured product include a method of curing an epoxy composition by heating to a predetermined temperature; a method of melting said epoxy composition with heating, injecting the melt into a mold and heating the mold, followed by molding; a method of melting said epoxy composition, injecting the resultant melt in a preheated mold and curing the melt; a method of filling a mold with a powder, which is obtained by partially curing said epoxy composition and grinding the resultant partially cured composition, and melt-molding the filled powder; and a method of optionally dissolving said epoxy composition in a solvent, partially curing with stirring, casting the resultant solution, removing the solvent through draft drying etc and optionally heating for a predetermined time while applying a pressure using a press etc.

A prepreg can be produced by optionally diluting an epoxy composition according to the present invention, applying or impregnating a base material with the composition and semi-curing the epoxy compound in the base material through heating the applied or impregnated base material. Examples of the base material include woven or nonwoven fabric made of an inorganic fiber, such as glass fiber woven fabric; and woven or nonwoven fabric made of an organic fiber such as polyester fiber. Using the prepreg, a laminate can be easily produced by a conventional method.

### EXAMPLES

Hereinafter, the present invention will be described in more detail by way of Examples, which should not be construed as limiting the scope of the present invention in any way.

### Example 1

Into a reactor equipped with a thermometer, a stirrer and a distillation condenser tube, 1-(3-methyl-4-hydroxyphenyl)-4-(4-hydroxyphenyl)-1-cyclohexene (25.0 g), epichlorohydrin (247.7 g) and potassium carbonate (61.6 g) were charged; and the resulting mixture was reacted at 50°C under a nitrogen atmosphere for 32 hours, while being stirred under heating. Ion-exchange water (100.0 g) was added to the resulting reaction mixture, which was then stirred at 50°C for 30 minutes while being thermally insulated. The reaction mixture was left to stand still, and the aqueous layer was separated from the mixture to obtain the organic layer. Sodium hydroxide (7.35 g) was added to the organic layer at 30°C, and the mixture was stirred for 4 hours while being thermally insulated. The insoluble component was removed from the reaction mixture by filtration.

The resulting reaction mixture was analyzed by liquid chromatography. As a result, the reaction mixture was found to contain an epoxy compound of the following formula (5) and an epoxy compound of the following formula (6); and the area percentages of these epoxy compounds were 94.3% and 3.3%, respectively:

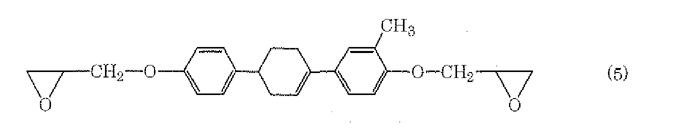

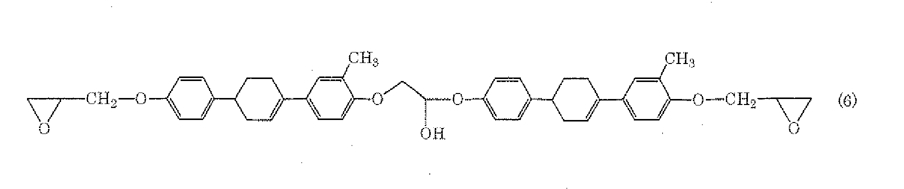

Ion-exchange water (100.0 g) was added to the resulting reaction mixture, which was then stirred at 50°C for 30 minutes while being thermally insulated. The reaction mixture was left to stand still, and then, the aqueous layer was separated therefrom to obtain the organic layer. The organic layer was concentrated at 50°C under reduced pressure, to thereby remove epichlorohydrin. Methanol (115.4 g) was added to the concentrated residue, and the resulting mixture was cooled to 10°C in 2 hours, and was stirred at the same temperature for 2 hours while being thermally insulated. The resulting slurry was filtered, and the resulting solid was washed with a 80% aqueous methanol solution (20 g) and a 40% aqueous methanol solution (20 g). Then, the solid was dried at 60°C under reduced pressure to obtain an epoxy composition as a white solid (27.5 g) which contained the epoxy compound of the formula (5) and the epoxy compound of the formula (6). The area percentages of the epoxy compound of the formula (5) and the epoxy compound of the formula (6) in the epoxy composition were 89.5% and 5.0%, respectively. The melting point of the epoxy composition was 126.0 to 135.5°C.

### Example 2

Into a reactor equipped with a thermometer, a stirrer and a distillation condenser tube, 1-(3-methyl-4-hydroxyphenyl)-4-(4-hydroxyphenyl)-1-cyclohexene (25.0 g), epichlorohydrin 247.7 g) and potassium hydroxide (15.0 g) were charged; and the resulting mixture was reacted at 50°C under a nitrogen atmosphere for 10 hours, while being stirred under heating. After completion of the reaction, the resulting reaction mixture was filtered at 50°C to remove the insoluble component.

The reaction mixture contained the epoxy compound of the formula (5) and the epoxy compound of the formula (6), and the area percentages of these compounds were 93.3% and 3.6%, respectively.

Ion-exchange water (100.0 g) was added to the reaction mixture, which was then stirred at 50°C for 30 minutes while being thermally insulated. The reaction mixture was left to stand still, and then, the aqueous layer was separated therefrom to obtain the organic layer. The organic layer was concentrated at 50°C under reduced pressure, to thereby remove epichlorohydrin. Methanol (115.4 g) was added to the concentrated residue, and the mixture was cooled to 10°C in 2 hours, and was then stirred at the same temperature for 2 hours while being thermally insulated. The resulting slurry was filtered, and the resulting solid was washed with a 80% aqueous methanol solution (50 g) and a 40% aqueous methanol solution (50 g). Then, the solid was dried at 60°C under reduced pressure to obtain an epoxy composition as a white solid (20.0 g) which contained the epoxy compound of the formula (5) and the epoxy compound of the formula (6). The area percentages of the epoxy compound of the formula (5) and the epoxy compound of the formula (6) in the epoxy composition were 93.3% and 4.9%, respectively. The melting point of the epoxy composition was 129.0 to 140.0°C.

### Example 3

Into a reactor equipped with a thermometer, a stirrer and a distillation condenser tube, 1-(3-methyl-4-hydroxyphenyl)-4-(4-hydroxyphenyl)-1-cyclohexene (25.0 g), epichlorohydrin (246.5 g) and sodium hydroxide (11.0 g) were charged; and the resulting mixture was reacted at 50°C under a nitrogen atmosphere for 6 hours, while being stirred under heating. After completion of the reaction, the resulting reaction mixture was filtered at 50°C to remove the insoluble component.
The reaction mixture contained the epoxy compound of the formula (5) and the epoxy compound of the formula (6), and the area percentages of these compounds were 87.1% and 8.5%, respectively.

Ion-exchange water (100.0 g) was added to the reaction mixture, which was then stirred at 50°C for 30 minutes while being thermally insulated. The reaction mixture was left to stand still, and then, the aqueous layer was separated therefrom to obtain the organic layer. The organic layer was concentrated at 50°C under reduced pressure, to thereby remove epichlorohydrin. Methanol (115.4 g) was added to the concentrated residue, and the mixture was cooled to 10°C in 2 hours, and was stirred at the same temperature for 2 hours while being thermally insulated. The resulting slurry was filtered, and the resulting solid was washed with a 80% aqueous methanol solution (50 g) and a 40% aqueous methanol solution (50 g). Then, the solid was dried at 60°C under reduced pressure to obtain an epoxy composition as a white solid (22.9 g) which contained the epoxy compound of the formula (5) and the epoxy compound of the formula (6). The area percentages of the epoxy compound of the formula (5) and the epoxy compound of the formula (6) in the epoxy composition were 89.2% and 4.5%, respectively. The melting point of the epoxy composition was 129.0 to 132.0°C.

### Example 4

Into a reactor equipped with a thermometer, a stirrer and a distillation condenser tube, 1-(3-methyl-4-hydroxyphenyl)-4-(4-hydroxyphenyl)-1-cyclohexene (25.0 g), epichlorohydrin (246.5 g) and sodium hydroxide (11.0 g) were charged; and the resulting mixture was reacted at 30°C under a nitrogen atmosphere for 12 hours, while being stirred under heating. After completion of the reaction, the resulting reaction mixture was filtered at 50°C to remove the insoluble component.

The reaction mixture contained the epoxy compound of the formula (5) and the epoxy compound of the formula (6), and the area percentages of these compounds were 80.9% and 13.6%, respectively.

Ion-exchange water (100.0 g) was added to the reaction mixture, which was then stirred at 50°C for 30 minutes while being thermally insulated. The reaction mixture was left to stand still, and then, the aqueous layer was separated therefrom to obtain the organic layer. The organic layer was concentrated at 50°C under reduced pressure, to thereby remove epichlorohydrin. Methanol (115.4 g) was added to the concentrated residue, and the mixture was cooled to 10°C in 2 hours, and was stirred at the same temperature for 2 hours while being thermally insulated. The resulting slurry was filtered, and the resulting solid was washed with a 80% aqueous methanol solution (50 g) and a 40% aqueous methanol solution (50 g). Then, the solid was dried at 60°C under reduced pressure to obtain an epoxy composition as a white solid (23.8 g) which contained the epoxy compound of the formula (5) and the epoxy compound of the formula (6). The area percentages of the epoxy compound of the formula (5) and the epoxy compound of the formula (6) in the epoxy composition were 82.2% and 13.6%, respectively. The melting point of the epoxy composition was 126.0 to 129.0°C.

### Example 5

Into a reactor equipped with a thermometer, a stirrer and a distillation condenser tube, 1-(3-methyl-4-hydroxyphenyl)-4-(4-hydroxyphenyl)-1-cyclohexene (25.0 g), epichlorohydrin (246.5 g) and tetrabutylammonium bromide (5.7 g) were charged, and the resulting mixture was reacted at 50°C under a nitrogen atmosphere for 6 hours, while being stirred under heating. After completion of the reaction, the resulting reaction mixture was cooled to 26°C, and was admixed with sodium hydroxide (7.3 g), and the mixture was further reacted at 25°C for 2 hours.

The reaction mixture contained the epoxy compound of the formula (5) and the epoxy compound of the formula (6), and the area percentages of these compounds were 96.4% and 2.1%, respectively.

Ion-exchange water (100.0 g) was added to the reaction mixture, which was then stirred at 50°C for 30 minutes while being thermally insulated. The reaction mixture was left to stand still, and the aqueous layer was separated therefrom to obtain the organic layer. The organic layer was concentrated at 50°C under reduced pressure, to thereby remove epichlorohydrin. Methanol (108.0 g) was added to the concentrated residue, and the mixture was cooled to 10°C in 2 hours, and was stirred at the same temperature for 2 hours while being thermally insulated. The resulting slurry was filtered, and the resulting solid was washed with a 80% aqueous methanol solution and ion-exchange water. Then, the solid was dried at 60°C under reduced pressure to obtain an epoxy composition as a white solid (30.7 g) which contained the epoxy compound of the formula (5) and the epoxy compound of the formula (6). The area percentages of the epoxy compound of the formula (5) and the epoxy compound of the formula (6) in the epoxy composition were 96.5% and 2.0%, respectively. The melting point of the epoxy composition was 128.0 to 140.0°C.

### Example 6

An epoxy composition is prepared by mixing the epoxy composition obtained in Example 5 and 4,4'-diaminodiphenylmethane. The epoxy composition thus prepared is heated and cured to obtain an epoxy resin-cured product. The epoxy resin-cured product shows a liquid crystalline property and a sufficient thermal conductivity.

### Example 7

An epoxy composition is prepared by mixing the epoxy composition obtained in Example 5, 4,4'-diaminodiphenylmethane and alumina. The epoxy composition thus prepared is heated and cured to obtain an epoxy resin-cured product. The epoxy resin-cured product shows a liquid crystalline property and a sufficient thermal conductivity.

### Example 8

An epoxy composition is prepared by mixing the epoxy composition obtained in Example 5, 4,4'-diaminodiphenylmethane and methyl ethyl ketone. The epoxy composition thus prepared was applied to a substrate and is then dried, and is further subjected to vacuum pressing to obtain a prepreg sheet. The substrate is peeled off from both surfaces of the prepreg sheet, and the prepreg sheet is sandwiched at its both surfaces between copper foils and is clad with the copper foils in vaccum. The resulting prepreg sheet is heated to obtain a resin sheet. The resin sheet shows a liquid crystalline property and a sufficient thermal conductivity.

### Example 9

An epoxy composition was prepared by mixing the epoxy composition (10 g) obtained in Example 5, 4,4'-diaminodiphenylmethane (2.4 g), alumina (11.9 g) and methyl ethyl ketone. The epoxy composition thus prepared was applied to a substrate and was then dried, and was further subjected to vacuum pressing to obtain a prepreg sheet. The substrate was peeled off from both surfaces of the prepreg sheet, and the prepreg sheet was sandwiched at its both surfaces between copper foils and was clad with the copper foils in vaccum. The resulting prepreg sheet was heated to obtain a resin sheet. The thermal coductivity of the resin sheet was 9.8 W/mk (measured by the xenon flash method).

### Reference Example 1

Into a reactor equipped with a thermometer, a stirrer and a distillation condenser tube, 1-(3-methyl-4-hydroxyphenyl)-4-(4-hydroxyphenyl)-1-cyclohexene (25.0 g), epichlorohydrin (244,9 g) and tetrabutylammonium bromide (5.8 g) were charged; and the resulting mixture was reacted at 50°C for 11 hours under a nitrogen atmosphere, while being stirred under heating. After completion of the reaction, the resulting reaction mixture was cooled to 20°C, and was admixed with sodium hydroxide (11.1 g), and the mixture was further reacted at 25°C for 2 hours.

The resulting reaction mixture contained the epoxy compound of the formula (5) and the epoxy compound of the formula (6), and the area percentages of these compounds were 96.2% and 0.8%, respectively.

The reaction mixture was concentrated at 50°C under reduced pressure, to thereby remove epichlorohydrin. To the resulting concentrated residue, methyl isobutyl ketone (246.7 g) and ion-exchange water (100.8 g) were added, and the resulting mixture was stirred at 50°C for 30 minutes while being thermally insulated. After left to stand still, the aqueous layer was separated from the mixture, to obtain the organic layer. The organic layer was refluxed at 50°C and dewatered, and was then cooled to 20°C in 20 minutes, to precipitate crystals. The resulting slurry was heated to 40°C and was then stirred at the same temperature for 3 hours while being thermally insulated. After that, the slurry was cooled to 10°C in 7 hours, and was then stirred at the same temperature for 2 hours while being thermally insulated. The resulting slurry was filtered to obtain a solid. The solid was washed with methyl isobutyl ketone (20 g) and was dried at 50°C under reduced pressure to obtain an epoxy composition as a white solid (27.3 g) which contained the epoxy compound of the formula (5) and the epoxy compound of the formula (6). The area percentages of the epoxy compound of the formula (5) and the epoxy compound of the formula (6) in the epoxy composition were 98.8% and 0.4%, respectively. The melting point of the epoxy composition was from 139.0 to 142.0°C.

### INDUSTRIALLY APPLICABLE FIELD

The epoxy compositions of the present invention show not only liquid crystalline properties but also high thermal conductivities, and are therefore useful as insulating materials which are required to have high heat dissipation capacities, for use in, for example, printed circuit boards, etc.

## Claims

1. An epoxy composition containing at least two kinds of epoxy compounds selected from the epoxy compounds of the formula (1) : 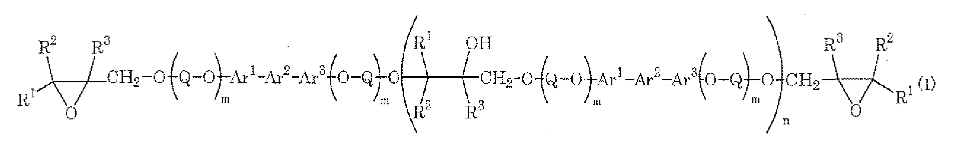 wherein
each of Ar¹, Ar² and Ar³, the same as or different from one another, is a bivalent group of any one of the following formulas: 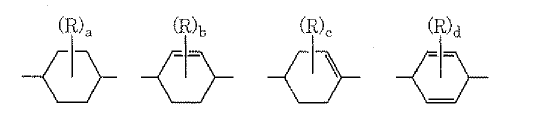 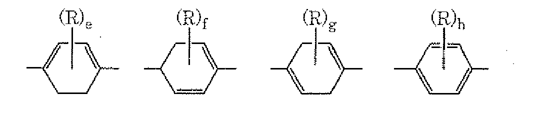 wherein R is a hydrogen atom or a C₁₋₈ alkyl group; a is an integer of 1 to 8; each of b, e and g is an integer of 1 to 6; c is an integer of 1 to 7; each of d and h is an integer of 1 to 4; and f is an integer of 1 to 5, wherein, when there are present a plurality of Rs in said bivalent group, Rs may be all the same groups or may be different groups from one another;
Q is a C₁₋₈ linear alkylene group, wherein a methylene group constituting the linear alkylene group may be substituted with a C₁₋₈ alkyl group, and wherein a methylene group, not adjacent to an oxygen atom, may be replaced by - 0-, and -0- or -N(R⁴)- may be inserted between methylene groups;
each of R¹, R², R³ and R⁴, the same as or different from one another, is a hydrogen atom or a C₁₋₈ alkyl group;
m is 0 or 1; and
n is an integer of 0 to 10.

2. The epoxy composition of Claim 1, which contains at least one kind of epoxy compound selected from the epoxy compounds of the formula (1) in which n is an integer of 1 to 10, and an epoxy compound of the formula (2): 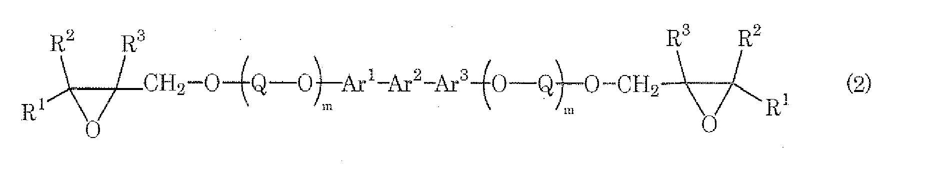 wherein Ar¹, Ar², Ar³, R¹, R², R³, Q and m are the same as defined above).

3. The epoxy composition of Claim 2, wherein the content of the epoxy compound of the formula (2) is 80% or more and 99% or less; and the content of at least one kind of epoxy compound selected from the epoxy compounds of the formula (1) in which n is an integer of 1 to 10 is 1% or more and 20% or less.

4. The epoxy composition of any one of Claims 1 to 3, which further contains a curing agent.

5. The epoxy composition of Claim 4, which further contains a filler.

6. A prepreg obtained by coating or impregnating a substrate with the epoxy composition of Claim 4, and semi-curing said epoxy composition.

7. A prepreg obtained by coating or impregnating a substrate with the epoxy composition of Claim 5, and semi-curing said epoxy composition.

8. An epoxy resin-cured product obtained by curing the epoxy composition of Claim 4.

9. An epoxy resin-cured product obtained by curing the epoxy composition of Claim 5.
